# EUROPÄISCHE PATENTSCHRIFT

(11) **EP 3 494 569 B1**
(45) Veröffentlichungstag und Bekanntmachung des Hinweises auf die Patenterteilung: **04.11.2020**
(21) Anmeldenummer: 17754601.7
(22) Anmeldetag: 01.08.2017
(51) Int. Cl.: G09F 9/33, H01R 13/717, H01R 13/514, H01R 13/66, H01R 33/02, H01R 33/88, H01R 33/92, H01R 103/00

(54) **MEHRFACH VERWENDBARE STECKMODULPLATINE AUS MEHREREN IN EINEM STECKMODULSYSTEM VERBINDBAREN STECKMODULEN MIT NACHTRÄGLICH ANSCHLIESSBAREN LEUCHTDIODEN. Z.B. FÜR DEN AUFBAU EINER LED-DEKORATION**
REUSABLE PLUG-IN MODULE CIRCUIT BOARD COMPRISING A PLURALITY OF PLUG-IN MODULES WHICH CAN BE CONNECTED IN A PLUG-IN MODULE SYSTEM AND HAVE LIGHT-EMITTING DIODES WHICH CAN BE RETROFITTED FOR EXAMPLE FOR CONSTRUCTING A DECORATIVE LED ARRANGEMENT
PLATINE DE MODULES ENFICHABLES À USAGE MULTIPLE, COMPOSÉE DE PLUSIEURS MODULES ENFICHABLES, RACCORDABLES DANS UN SYSTÈME DE MODULES ENFICHABLES, AVEC DES DIODES ÉLECTROLUMINESCENTES (LED) CONNECTABLES ULTÉRIEUREMENT, PAR EXEMPLE POUR LA CONSTRUCTION D'UNE DÉCORATION LED

(30) Priorität: 04.08.2016 DE 202016004792 U; 01.06.2017 DE 102017005223
(43) Veröffentlichungstag der Anmeldung: 12.06.2019
(73) Patentinhaber: Jeon-Haurand, Hyeon Sook, 50321 Brühl (DE)
(72) Erfinder: Jeon-Haurand, Hyeon Sook, 50321 Brühl (DE)
(74) Vertreter: Koch, Theodor
(86) Internationale Anmeldenummer: PCT/DE2017/000241
(87) Internationale Veröffentlichungsnummer: WO 2018/024273

(56) Entgegenhaltungen:
- US-A1- 2005 239 342
- US-A1- 2005 239 342
- US-A1- 2013 163 234
- US-A1- 2013 163 234

## Beschreibung

In herkömmlichen Steckmodulplatinen sind die zu verwendenden Leuchtdioden (LED's) fest angeschlossen vorgegeben.

Die Steckmodule weisen eine große Anzahl fest angeschlossener Leuchtdioden auf. Es ist bekannt Leuchtdioden-Steckmodule in Form einer Leuchtdiodenmatrix aus einzelnen quadratischen plattenartigen Segmenten von 4,5 cm x 4,5 cm aufzubauen, welche jeweils neun Leuchtdioden aufweisen, welche mit 12 Volt bei 1,8 Watt betrieben werden. Ein Matrix-Segment erreicht bis zu 160 Im und eine Modul-Effizienz von fast 90 lm/W. Die Matrix lässt sich theoretisch nahtlos zu unendlichen Strängen, Flächen oder komplexen Formen kombinieren, ganz ohne Löten und Basteln. Die Matrix kann in vorgefertigten Segmentgrößen bestellt, aber auch von Hand nach eigenen Wünschen vergrößert und verkleinert werden. Der elektrische Anschluss der einzelnen Matrix-Segmente erfolgt für alle Leuchtdioden des Segmentes gemeinsam über einen kleinen seitlich ansetzbaren Kontaktblock mit zwei Anschlusskabeln. Es leuchten somit alle neun Leuchtdioden eines an Spannung gelegten Matrix-Segmentes gleichzeitig auf. Eine derartige Leuchtiodenmatrix wird von der Firma LUMITRONIX LED-Technik GmbH, 72379 Hechingen angeboten. Eine beliebige Form einer Leuchtdioden-Dekoration, z.B. in einer herzförmigen Kontur, ist mit diesen Matrix-Segmenten aber nicht möglich.

Bei herkömmlichen einfachen Platinen müssen die einzelnen Leuchtdioden entsprechend der gewünschten Form der Lichterkette auf rasterförmig über die Platinenoberfläche fabrikmäßig verteilt vorgesehenen Anschlusspunkte angelötet werden. Die Verbindung entsprechender elektrischer Anschlüsse erfolgt auf den einzelnen Platinen durch anzulötende Anschlusskabel.

Die Erstellung komplexer, insbesondere dreidimensionaler Formen ist insofern nicht möglich.

Des weiteren ist die Erstellung einer Leuchtdioden-Dekoration, z.B. in herzförmiger Kontur, äußerst aufwendig. US 2013/163234 A1 offenbart eine Steckmodulplatine, die aus mehreren zu dieser zusammenfügbaren Steckmodulen besteht. US 2005/239342 A1 offenbart ein Leuchtmodul, das eine oder mehrere Lichtquellen aufweist.

Das erfindungsgemäße Steckmodulsystem soll ohne Löten den Aufbau unterschiedlicher Arten von LED Dekorationen aus Steckmodulen ermöglichen und dies auch in unterschiedlicher Größe und Form des Steckmodulsystems bzw. der Steckmodule der Steckmodulplatine in ein-, zwei- und dreidimensionaler Weise.

Ausgehend von bekannten Steckmodulplatinen bestehend aus mehreren zu dieser zusammenfügbaren segmentartigen Steckmodulen mit elektrischer Kontaktierung zur Bestückung und zum Spannungsanschluss der Leuchtdioden auf der Platinenoberfläche ist erfindungsgemäß eine Ausbildung der Steckmodule gemäß Anspruch 1 vorgesehen. Die Leichtdioden können somit mit ihren Diodenbeinen auf als Rast- und Steckvorrichtung ausgebildeten Kontaktierungen einzeln aufgesteckt und durch einen gemeinsamen positiven oder negativen elektrischen Anschluss der in senkrechten Reihen verbundenen Steckmodule mit Spannung versorgt werden.

Vorteilhafte Ausführungen der Erfindung ergeben sich aus den Ansprüchen 1 - 14.

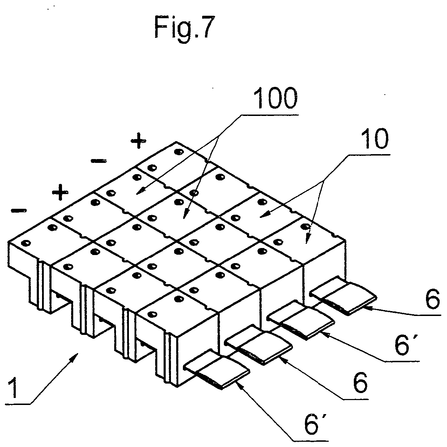

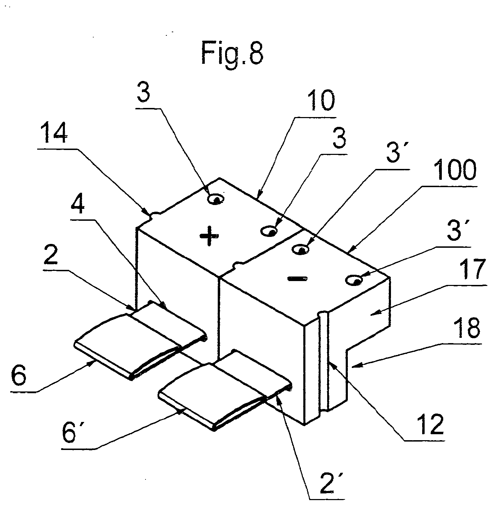

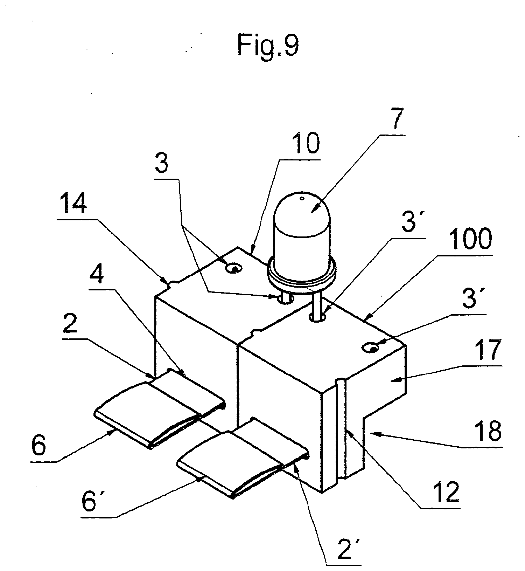

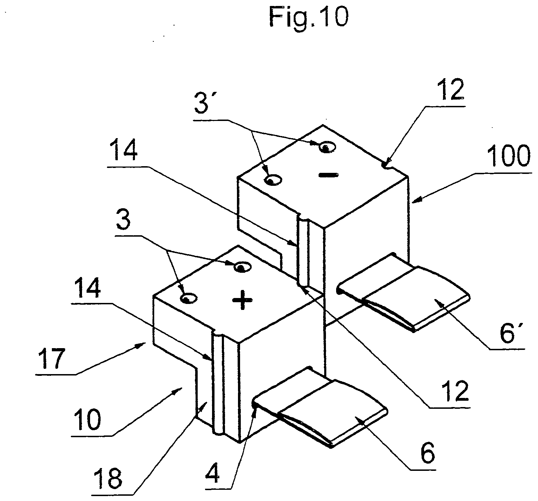

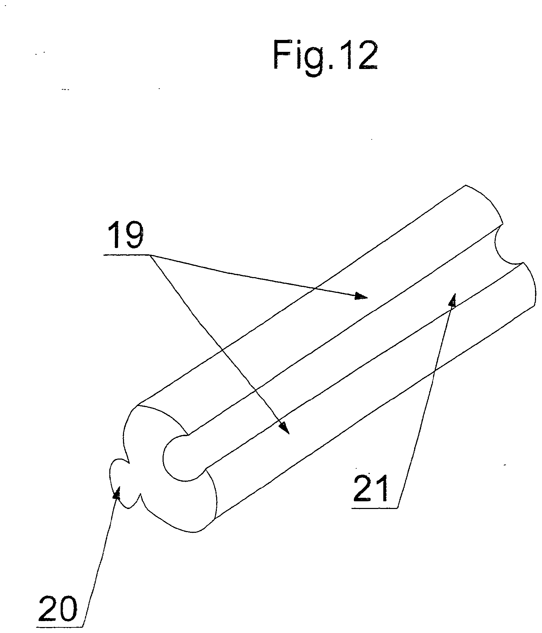

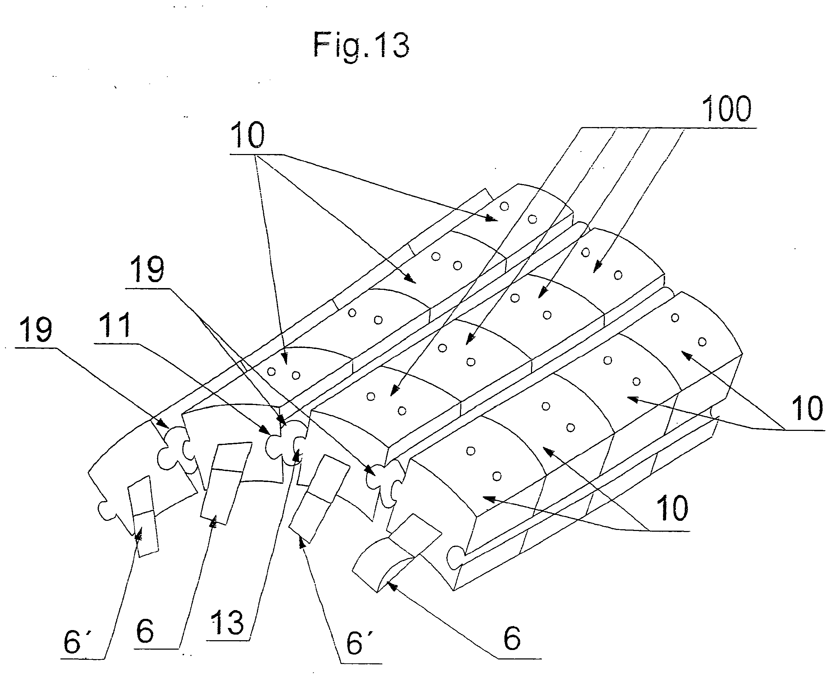

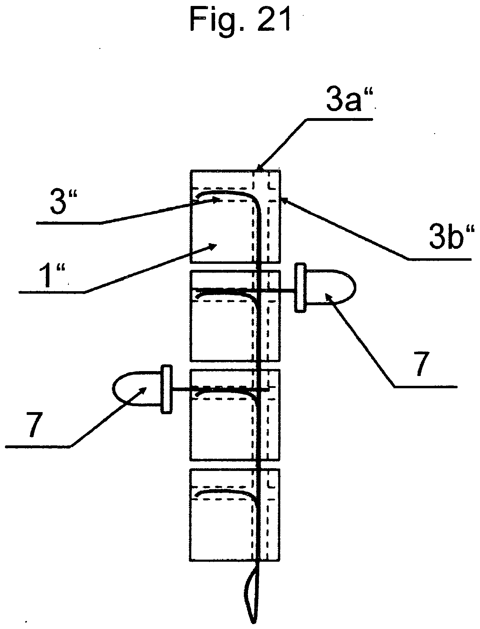

In den Zeichnungen sind vorteilhafte Ausführungsformen der Erfindung in Figuren 1 - 21 dargestellt, welche im Folgenden näher erläutert werden.

In den Zeichnungen zeigen:
Figur 1 eine Seitenansicht eines Steckmoduls aus Anschlussgehäuse mit Kontaktfederstreifen und zwei oberen Kontaktierungen für die Diodenbeine der gemäß Figur 9 anzuschließenden Leuchtdioden.
Figur 2 eine Querschnittansicht durch das Steckmodul mit Anschlussgehäuse gemäß Figur 1 längs einer der beiden oberen Führungsbohrungen und der unteren breiteren Führungsbohrung zur Anlage der Kontaktierung bzw. des Kontaktfederstreifens.
Figur 3 zwei seitliche, über horizontale Rastrippen und Längsausnehmungen verbundene, zueinander verschobene Anschlussgehäuse, jeweils mit dargestelltem vorderen unteren Endabschnitt der Kontaktfederstreifen, in perspektivischer Darstellung.
Figur 4 eine Abwandlung der Anschlussgehäuse unter Darstellung einer Raststruktur an den Außenseiten sowohl aus horizontalen als auch vertikalen Längsausnehmungen und Rastrippen.
Figur 5 eine Darstellung gemäß Figur 2 in Seitenansicht statt Querschnitt unter Darstellung zweier in einer senkrechten Reihe hintereinander zu übersteckender, zunächst noch beabstandeter Steckmodule mit einer Öffnung in der unteren Führungsbohrung für den als Rast- und Steckabschnitt dienenden vorderen Endabschnitt des Kontaktfederstreifens des hinteren Steckmoduls.
Figur 6 eine Draufsicht auf eine Steckmodulplatine gebildet aus jeweils vier seitlich in einer horizontalen Reihe angeordneten, über eine Raststruktur verbundenen Steckmodulen, welche zusätzlich in vier senkrechte, ebenfalls mit vier Steckmodulen Reihen hintereinander übersteckt sind und somit aus 16 Steckmodulen bestehen. Die Übersteckung erfolgt jeweils mit einem nach vorne vorstehenden Endabschnitt der auch zur Spannungskontaktierung verwendeten Kontaktfederstreifen.
Figur 7 eine perspektivische Ansicht der gemäß Figur 6 übersteckten 16 Steckmodule.
Figur 8 eine perspektivische Darstellung zweier seitlich verbundener Anschlussgehäuse, welche über eine vertikale Längsausnehmung und eine auf der gegenüberliegenden Außenseite liegende vertikale Rastrippe miteinander verbunden sind, jeweils mit Kontaktfederstreifen und vorstehenden unteren Endabschnitt davon.
Figur 9 eine Darstellung gemäß Figur 8 mit angeschlossener Leuchtdiode, wobei jeweils ein Diodenbein in die angrenzenden Kontaktierungen der zwei miteinander verbundenen Anschlussgehäuse eingesteckt ist und über die vorstehenden Endabschnitte der Kontaktfederstreifen dieser Anschlussgehäuse an eine Spannung anschließbar sind.
Figur 10 eine Darstellung gemäß Figur 9 über eine Außenseite miteinander verbundene Anschlussgehäuse, welche im Gegensatz zur Figur 9 seitlich in unterschiedlicher Höhe miteinander verbunden sind.
Figur 11 eine Anordnung von in einer quadratischen Matrix einer Steckmodulplatine angeordneten Steckmodulen, wobei in einer horizontalen Reihe und einer vertikalen Reihe jeweils 17 Steckmodule vorgegeben sind und auf der Oberseite der Steckmodule die Leuchtdioden unter Darstellung eines herzförmigen Umrisses in die vorgesehenen Kontaktierungen der Oberseite der Anschlussgehäuse gesteckt sind.
Figur 12 eine Verbindungsstange in perspektivischer Ansicht für die Beabstandung der Anschlussgehäuse zweier seitlich miteinander zu verbindender Steckmodule mit Längsrippe und Längsausnehmung, welche in die Raststruktur aus Längsausnehmungen und Rastrippen an den Außenseiten der Anschlussgehäuse passen.
Figur 13 eine mit gebogener Oberfläche ausgebildete Steckmodulplatine unter Verwendung der Verbindungsstangen gemäß Figur 12, wobei die einzelnen seitlich zueinander angeordneten Steckmodule gegeneinander in einem Winkel angestellt sind, entsprechend den in einem Winkel angestellten Rastrippen und Längsausnehmungen der Verbindungsstange.
Figur 14, 15 zeigen zwei bezüglich ihrer Kontaktfederstreifen abgeänderte Steckmodule.
Figur 16-17 zeigen die Rückseite bzw. rechte Außenseite einer aus drei senkrechten Reihen von Steckmodulen aufgebauten Steckmodulplatine mit gestecktem Widerstand.
Figur 18 zeigt an den zwei Außenseiten in der Mitte dargestellten größeren zweireihigen Steckmodule mit einer seitlichen konkaven oder vorspringenden horizontalen Raststruktur jeweils seitlich anstehende um 90 ° gedrehte miteinander verbundene Steckmodule mit passender konkaver horizontaler Raststruktur an ihrer Rückseite.
Figur 19 zeigt zwei zu deren Verbindung verwendete Verbindungsstangen.
Figur 20 zeigt ein alternatives Anschlussgehäuse zur Bildung eines Steckmoduls.
Figur 21 zeigt die seitliche Ansicht eines eindimensionalen Steckmodulsystems aus diesen alternativen Anschlussgehäusen mit zwei LEDs.

Für die Anschlussgehäuse (1') der Steckmodule (10, 100) sind unterschiedlichste Materialien verwendbar, vorzugsweise hartes Plastik oder weiches Silikon.

Die Größe der erfindungsgemäßen Steckmodulplatine (1) aus einzelnen Steckmodulen (10, 100) ist entsprechend der verwendeten, miteinander verbindbaren Steckmodulanzahl variierbar. Die matrixartig zusammensteckbaren Steckmodule (10, 100) bestehen aus zwei Teilen, nämlich aus einem mit einem Endabschnitt (6) seitlich vorragenden Kontaktfederstreifen (2, 2') mit zwei oberen Kontaktierungen (8, 8') der Leuchtdioden (7) und dem diese Anschlüsse aufnehmenden Anschlussgehäuse (1'). Sie ermöglichen eine saubere Leuchtdioden-Dekoration auf der Oberseite, da dort der Anschluss der Leuchtdioden (7) mit jeweils einem Diodenbein an seitlich zueinander angrenzenden positiven und negativen Kontaktierungen (8, 8'), also über somit gebildete Steckbrücken der Leuchtdioden erfolgt und alle anderen Verbindungen untereinander auf der Vorder- und Rückseite sowie den Außenseiten der Steckmodule (10, 100) gesteckt werden können.

Das Steckmodulsystem ist nach Entfernen der Leuchtdioden (7) und nach Auseinandernehmen der zur Steckmodulplatine (1) verbundenen Steckmodule (10, 100) und mit Wiederzusammensetzung der Steckmodule (10, 100) mehrfach verwendbar.

### Aufbau

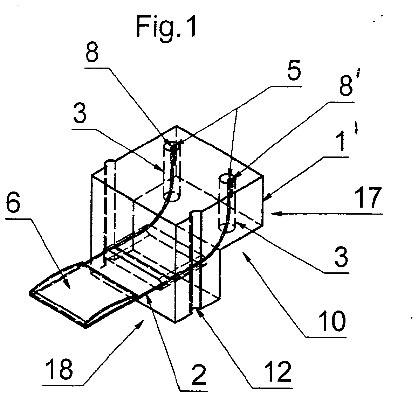

Die Steckmodule (10, 100) bestehen aus zwei Teilen, wie z.B. in den Figuren 1, 2 und 3 dargestellt, nämlich einem Anschlussgehäuse (1') und einem dort jeweils angeordneten Kontaktfederstreifen (2, 2') mit Kontaktierungen (8, 8').

In dem Anschlussgehäuse (1') ist jeweils ein Kontaktfederstreifen (2) mit zwei oberen Abschnitten in zwei von der hinteren Gehäuseoberseite zur Unterseite der Steckmodule geführten oberen Führungsbohrungen (3, 3') gelagert. Diese Anschlüsse sind über eine untere breitere Führungsbohrung (3a) als gemeinsamer Abschnitt zu einer einzigen breiten Öffnung (4) geführt und damit dort somit mit dem gemeinsamen Abschnitt eingebaut.

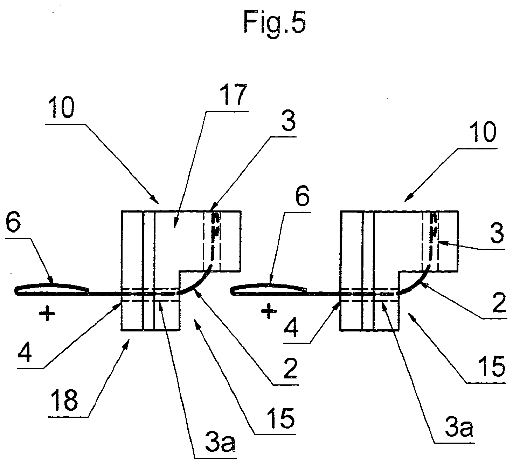

Die beiden oberen Enden (5) des Kontaktfederstreifens (2, 2') sind mit dem unteren Endabschnitt (6) halbrund zueinander gebogen, damit die Steckmodule gleicher Polarität mittels der zu übersteckenden Kontaktfederstreifen (2, 2') fest verbindbar sind (Figur 5).

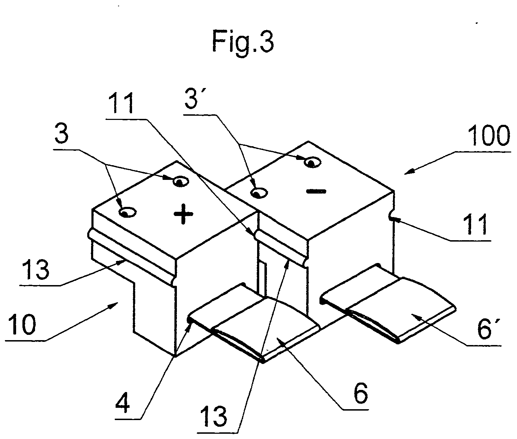

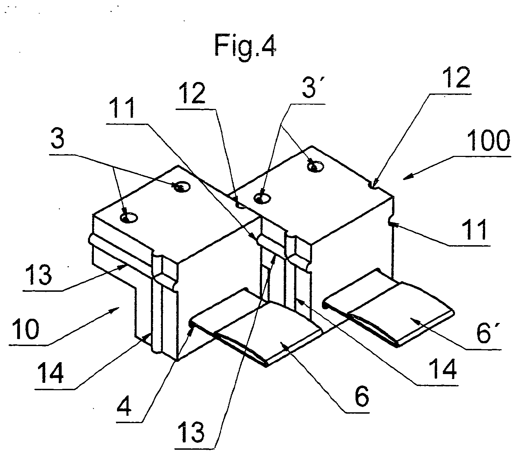

Die beiden rechten und linken Außenseiten des Anschlussgehäuses (1') werden mit einer Raststruktur sowohl aus waagerecht als auch aus senkrecht verlaufenden Längsausnehmungen (11, 12) und aus seitlich vorspringenden horizontalen und vertikalen Rastrippen (13, 14) gebaut, damit die Steckmodule in einer Ebene nebeneinander und höhenunterschiedlich verbunden werden können (Figur 4). Damit sind die Steckmodule (10, 100) nebeneinander und höhenunterschiedlich verbindbar. Alternativ ist gemäß Figur 3 lediglich eine in horizontaler Richtung verlaufende Raststruktur angelegt.

Eine runde, konkave und konvexe Struktur der beiden Außenseiten des Anschlussgehäuses (1') ermöglicht unter den Anschlussgehäusen (1') zweier benachbarter Steckmodule (10, 100) eine kurvenförmig veränderbare Verbindungsfläche der beiden Anschlussgehäuse mit positiver oder negativer Polarität.

Die Steckmodule (10) gleicher Polarität sind gemäß Figur 5 durch die halbrund gebogenen und in einer oberen und in einer unteren breiteren Längsbohrung gelagerten vorspringenden Kontaktfederstreifen (2) in einer Reihe hintereinander übersteckbar. Gemäß Figur 5 ist die Übersteckung von Steckmodulen (10) mit positiver Polarität dargestellt. Diese hintereinander angeordneten, zu verbindenden Steckmodule (10) bilden einen gemeinsamen Leiterstreifen.

Dabei erfolgt eine Übersteckung des am unteren Ende der Kontaktfederstreifen (2) gegebenen Endabschnittes (6) des hinteren Steckmoduls (10) in die breite Öffnung (4) der unteren Führungsbohrung (3a) an der Auslassung (15) des Anschlussgehäuses des vorderen Steckmoduls (10), also mit dem dort sich erstreckenden halbrund abgebogenen Kontaktfederstreifen (2).

### Beispiel:

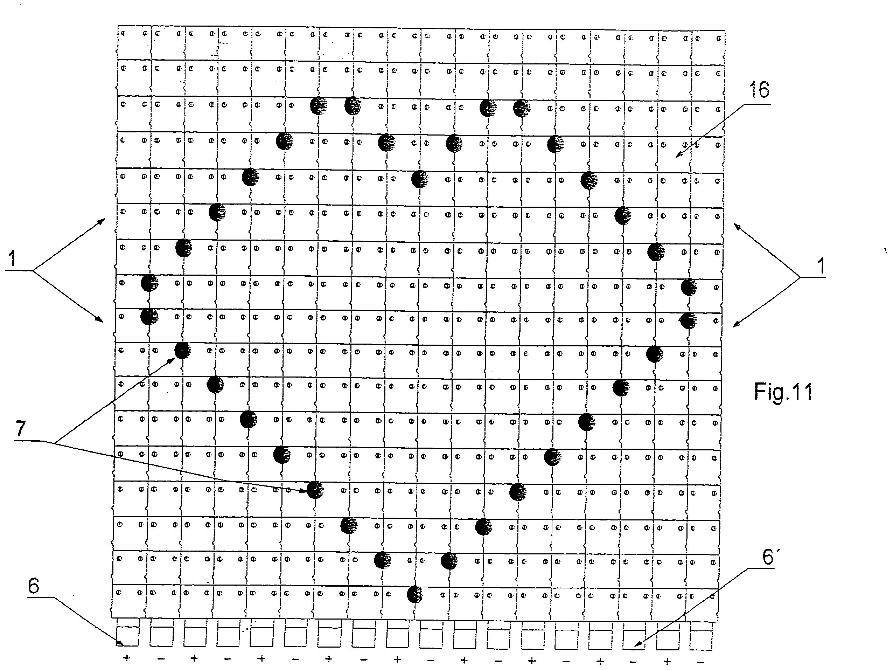

Eine Herzdekoration mit aufgesteckten Leuchtdioden gemäß Figur 11.

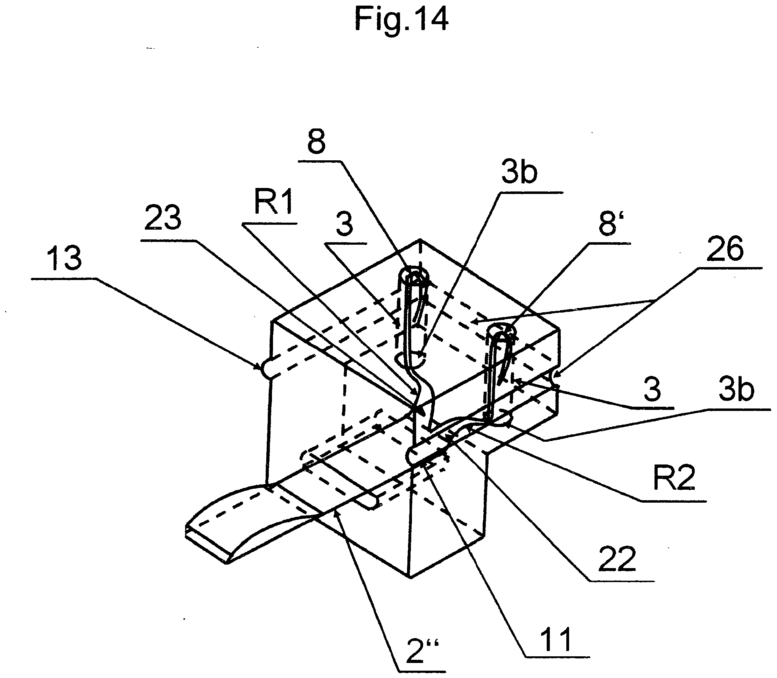

Abwandlungen dieser Ausführungen in spezieller Anwendung sind in Figur 14-18 gezeigt. Es zeigen Figur 14 und 14-1 zwei Steckmodule mit Abänderungen der Kontaktfederstreifen

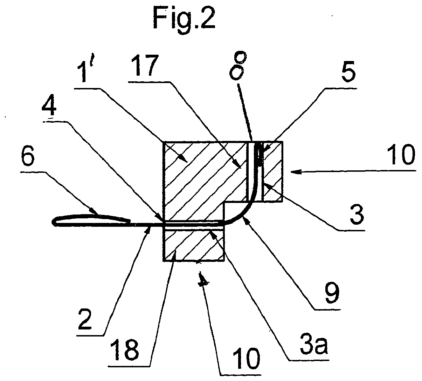

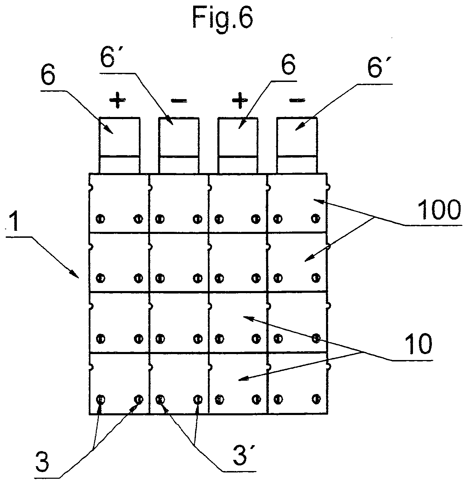

Bei diesen Steckmodulen sind die elektrischen Verbindungen zwischen den zwei oberen Kontaktierungen (8, 8') in den oberen beiden Führungsbohrungen (3, 3') und dem Kontaktstreifen (2") in der unteren breiten in Figur 2 und 6 in Querschnittsansicht gezeigten Führungsbohrung (3a) nicht als Draht ausgebildet, sondern im Querschnitt als geschnittene hülsen- oder plattenförmige elektrische Verbindungskontaktteile (22, 23), welche nach innen mit einem Radius (R1; R2) aufeinander zugebogen sind. Damit wird eine mögliche teilweise Blockierung der unteren Seiten der zwei oberen Führungsbohrungen (3, 3') durch die eingesteckten, zum Kontaktfederstreifen (2") verlaufenden Abschnitte der Verbindungskontakteile (22, 23) vermieden. Der Bereich der Öffnung zu der unteren Seite der zwei oberen Führungsbohrungen (3, 3') ist mit (3b) bezeichnet.

Diese Abbiegungen dienen zur besseren Anschlussmöglichkeit von für eine elektrische Schaltung notwendige Bauteile, wie z. B Steckbrücken, Widerstände usw., an der Rückseite der Steckmodule der Stechmodulplatine (1) bzw. an der dortigen Öffnung der unteren Seite der zwei oberen Führungsbohrungen (3, 3').

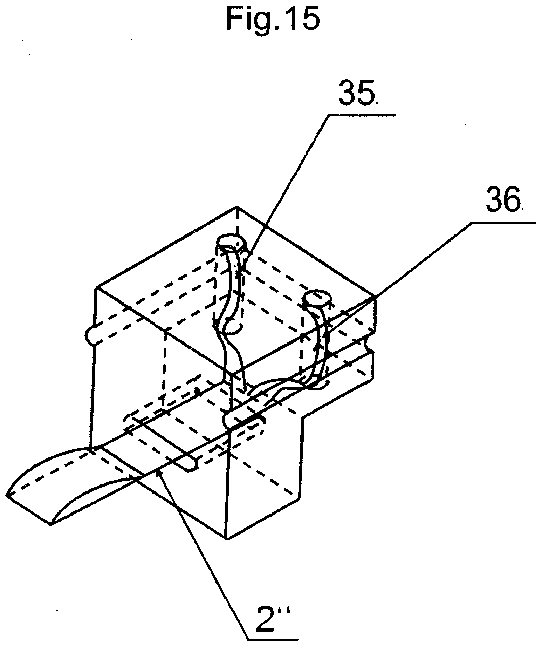

Figur 15 zeigt eine zur Figur 14 geänderte Abbiegeform (35, 36) des Kontaktfederstreifens (2"). In beiden Ausführungsformen sind, wie auch in Figur 3 und 4 gezeigt, seitliche konkave bzw. konvexe horizontale Raststrukturen (11.13) an den Steckmodulen vorhanden.

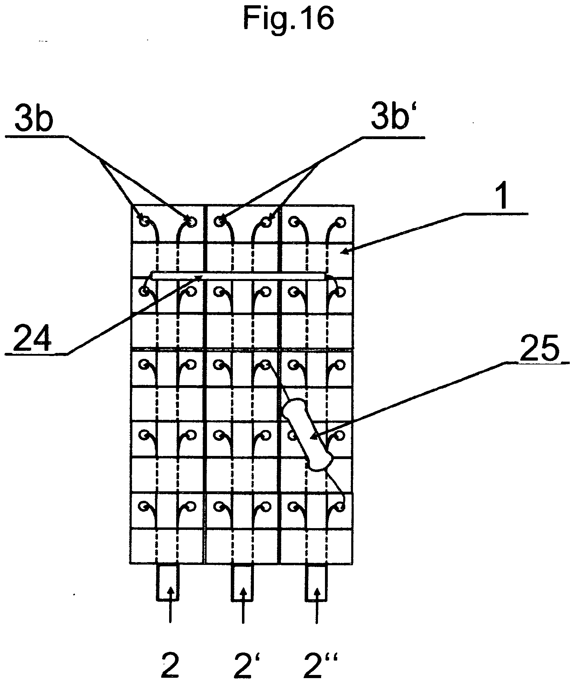

Figur 16 zeigt die Rückseite der Steckmodulplatine (1) mit einer gesteckten Steckbrücke (24) und einem gesteckten Widerstand (25).

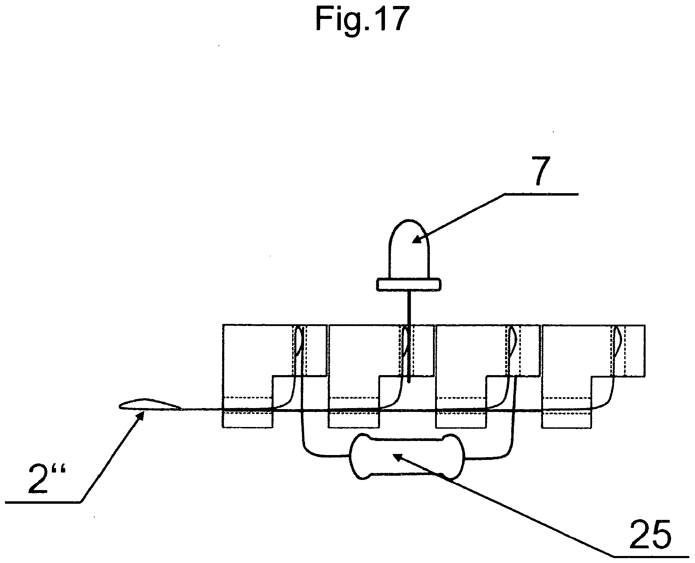

Figur 17 zeigt die seitliche Ansicht gemäß der Zeichnung der Figur 16 von rechts.

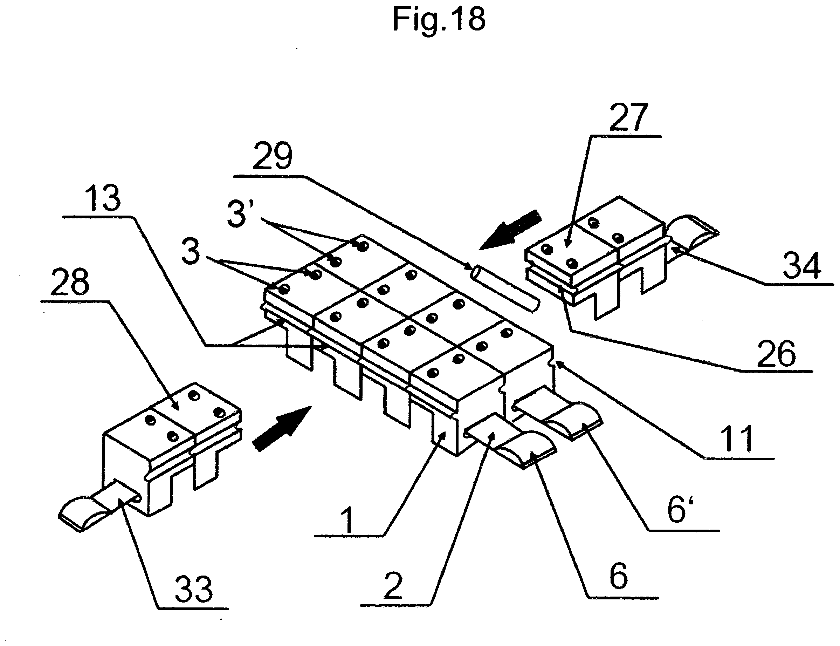

Ergänzend zu der seitlichen konkaven bzw. konvexen horizontalen Raststruktur (11. 13) in Figur 15 sowie Figur 3, 4 befindet sich gemäß Figur 14 und 18 noch eine konkave horizontale Raststruktur (26) an der Rückseite der Steckmodule.

Diese Raststruktur (26) ermöglicht eine nunmehr seitliche Verbindung von Steckmodulen, welche um 90° senkrecht gegen die Steckmodule einer vertikalen Steckmodulreihe gedreht sind, mit diesen Steckmodulen der vertikalen Steckmodulreihe.

Figur 18 zeigt eine senkrechte Verbindung zweier äußerer Steckmodule an der linken Seite der Steckmodulplatine (1). Für die Verbindung an der rechten äußeren Seite der Steckmodulplatine (1) benötigt man aufgrund der gegenüberliegenden beiden horizontalen konkaven Raststrukturen eine zusätzliche Verbindungsstange (29).

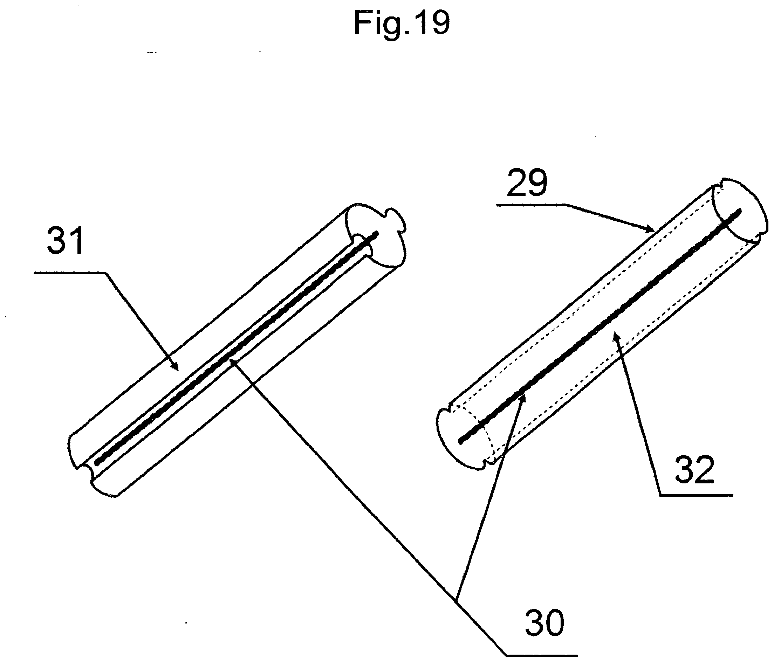

Figur 19 zeigt zwei verschiedene Verbindungsstangen (29) mit einem Metallkern (30), die mit eine flexiblen Ummantelung (31, 32) umgeben sind.

Der Metallkern unterstützt bei beliebigen flexiblen dreidimensionalen Formbildungen aus den Steckmodulen die Stabilität der Form der gebildeten Steckmodulplatine.

Fig. 19 zeigt ein alternatives Anschlussgehäuse (1"). Dieses ist im Vergleich zum originalen Anschlussgehäuse (1') (siehe Fig. 1) so geändert, dass die gesamte Würfelform bestehen bleibt und die zwei oberen Führungsbohrungen (3) bis zur unteren Seite dieser Würfelform verlaufen, so wie die untere breite Führungsborhung (3a) bis zur hinteren Seite der Würfelform verläuft.

Dies alternative Anschlussgehäuse (1") dient zur Bildung einer freien Rückseite der Steckmodulplatine, somit sind die LEDs sowohl von der Vorderseite als auch von der Rückseite des Steckmoduls steckbar. Dies seitlich duale Stecksystem spielt eine sehr günstige Rolle beim dreidimensionalen LED Deko- oder Beleuchtungssystembau.

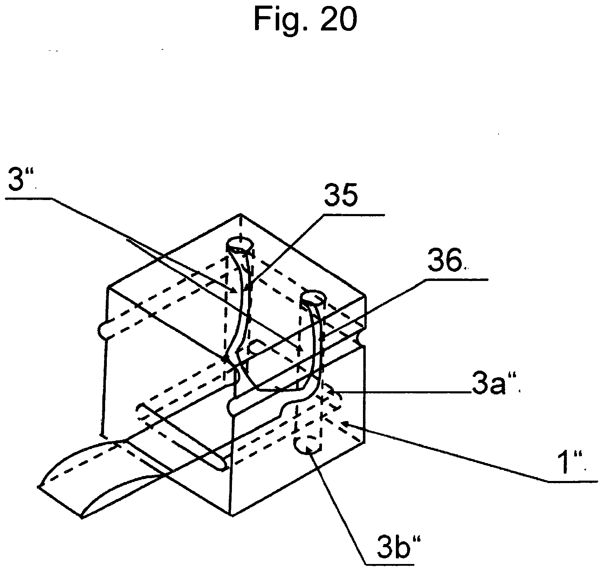

Fig. 20 zeigt eine seitliche Ansicht eines eindimensionalen Steckmodulsystems aus diesen alternativen Anschlussgehäusen mit jeweils einem von zwei LEDs auf der Vorder- und Rückseite der Steckmodulplatine mit dem alternativen Anschlussgehäuse (1").

### Bezugsziffernliste

- 1: Steckmodulplatine mit Steckmodulen
- 1': Anschlussgehäuse eines Steckmoduls
- 1": Alternatives Anschlussgehäuse
- 2, 2', 2": Kontaktfederstreifen zweier benachbarter Steckmodule
- 3: Zwei benachbarte obere rechte bzw. linke Führungsbohrungen zur Oberseite des Anschlussgehäuses verlaufend zur Aufnahme der Kontaktierung eines ersten Diodenbeins (Pluspol) einer Leuchtdiode
- 3': Zwei benachbarte obere rechte und linke Führungsbohrungen (Löcher), die zur Oberseite eines zum linken Anschlussgehäuse benachbarten rechten Anschlussgehäuses verlaufen, zur Aufnahme der Kontaktierung eines zweiten Diodenbeins (Minuspol) der Leuchtdiode im benachbarten Steckmodul
- 3": Zwei obere bis zur unteren Seite des Steckmoduls verlaufende Führungsbohrungen im alternativen Anschlussgehäuses (1")
- 3a: Untere Führungsbohrung
- 3a": Untere breite bis zur hinteren Seite des Steckmoduls verlaufende Führungsbohrung im alternativen Anschlussgehäuse (1")
- 3b; 3b': Bereich der Öffnung zu der unteren Seite der zwei oberen Führungsbohrungen eines Steckmoduls
- 4: Breite Öffnung der Führungsbohrung für den Kontaktfederstreifen auf der vorderen Stirnseite des Gehäuses sich öffnend
- 5: Zwei obere Kontaktierungen des Kontaktfederstreifens eines Steckmoduls am oberen Ende der in dessen linke oder rechte obere Führungsbohrung (3) ragenden abgebogenen Abschnitte des Kontaktfederstreifens für die Verbindung und zum elektrischen Anschluss jeweils einer der beiden Diodenbeine einer Leuchtdiode in der oberen rechten und linken Führungsbohrung (3, 3') jeweils eines zweier angrenzender Steckmodule in Art einer übergreifenden Steckbrücke
- 6: Vorderer unterer gemeinsamer Endabschnitt des in die beiden linken oberen Führungsbohrungen (3) mit Kontaktabschnitten ragenden Verbindungskontaktteils des Kontaktfederstreifens (2)
- 6': Vorderer unterer gemeinsamer Endabschnitt der in die beiden rechten oberen Führungsbohrungen (3') ragenden Verbindungskontaktteils des Kontaktfederstreifens (2')
- 2, 6; 2', 6': Rast- und Steckabschnitt
- 7: Leuchtdioden mit Diodenbeinen, welche über die Kontaktfederstreifen zweier benachbarter Gehäuse im oberen Bereich der Führungsbohrungen (3, 3') einsteckbar sind
- 8, 8': Zwei Kontaktierungen des Kontaktfederstreifens für den Steckanschluss jeweils einer der Diodenbeine einer Leuchtdiode in der oberen rechten und linken Führungsbohrung (3) des jeweiligen benachbarten Steckmoduls in Form einer übergreifenden Steckbrücke
- 9: Abbiegung der Enden (5, 6) des Kontaktfederstreifens (2) zur Erzeugung des Stecksystems (8)
- 10: Steckmodule gleicher Polarität, positiv
- 100: Seitliche Steckmodule dazu, gleiche Polarität, negativ
- 11: Raststruktur zur Verbindung seitlich benachbarter Steckmodule aus konkaver horizontaler Längsausnehmung an der rechten Außenseite des Gehäuses (1)
- 12: Raststruktur zur Verbindung seitlich benachbarter Steckmodule aus konkaver vertikaler Längsausnehmung an der rechten Außenseite des Gehäuses (1)
- 13: Seitlich vorspringende horizontaler Rastrippen an der linken Außenseite des Gehäuses (1) zur Führung in der äußeren seitlichen horizontalen Längsausnehmung eines benachbarten Gehäuses
- 14: Seitlich vorspringende vertikale Rastrippen an der linken Außenseite des Gehäuses (1) zur Führung in der äußeren seitlichen vertikalen Längsausnehmung eines benachbarten Gehäuses
- 15: rückseitige Auslassung eines Steckmoduls mit innerer unterer Öffnung der unteren Führungsbohrung (3a) mit Steckaufnahmen für den vorderen Rast- und Steckabschnitt des Kontaktfederstreifens des in gleicher Längsrichtung dort zu übersteckenden weiteren hinteren Steckmoduls (10) gleicher Polarität
- 16: Oberseite der Platine bzw. des Layouts der Steckmodule für den Aufbau der LED-Dekoration mit positiven und negativen Kontaktierungsleitungen für die Spannung der Kontaktfederstreifen bzw. der jeweils beiden Diodenbeine der Leuchtdioden, welche auf den Oberseiten zweier benachbarter Steckmodule in Form von Brücken eingesteckt sind.
- 17: hinterer oberer Gehäuseansatz
- 18: vorderer, zum hinteren obereren Gehäuseansatz tiefer verlaufender Gehäuseansatz
- 19: Verbindungsstangen
- 20: Längsrippe
- 21: Längsausnehmung
- 22, 23: in einem Abschnitt nach innen gebogenes elektrisches Verbindungskontaktteil mit Kontaktabschnitten
- 24: Steckbrücke
- 25: Widerstand
- 26: konkave horizontale Raststruktur an der Rückseite des Steckmoduls (27, 28)
- 27: Steckmodul zum zusätzlichen seitlichen Anstecken an einem benachbarten Steckmodul mit an seiner Rückseite zusätzlich angelegter konkaver horizontaler Raststruktur gegen eine angrenzende konkave Raststruktur des benachbarten Steckmoduls durch eine diese konkaven angrenzenden Raststrukturen verbindende und in diese festklemmbare Verbindungsstange
- 28: Steckmodul zum zusätzlichen seitlichen Anstecken an einem benachbarten Steckmodul mit an seiner Rückseite zusätzlich angelegter konkaver horizontaler Raststruktur in einer angrenzenden horizontalen Rastrippe (13) des benachbarten Steckmoduls
- 29: Verbindungsstange für angrenzende konkave horizontale Raststrukturen (26)
- 30: Metallkern der Verbindungsstange
- 31,32: Ummantelung des Metallkerns der Verbindungsstange
- R1; R2: nach innen erfolgte konkave Abbiegung der Verbindungskontaktteile (22, 23)
- 33, 34: Kontaktfederstreifen der Steckmodule (27, 28)
- 35, 36: Alternative Abbiegung des Kontaktfederstreifens für den Anschluss des Diodenbeins einer Leuchtdiode (7)

## Patentansprüche

1. Steckmodulplatine bestehend aus mehreren zu dieser zusammenfügbaren Steckmodulen mit elektrischen Kontaktierungen zur Bestückung mit Leuchtdioden und/oder Spannungsanschluss, wobei die Steckmodule (10, 100) aus einzelnen block- oder würfelförmigen Anschlussgehäusen (1') bestehen, wobei die Steckmodule (10, 100) zur Bildung von seitlichen Platinenlängsreihen aus mehreren seitlich aneinander gesetzten Anschlussgehäusen (1') bestehen, welche an mindestens einer ihrer Außenseiten eine Raststruktur (11, 12; 13, 14, 26) aus waagerecht und/oder aus senkrecht zu einander verlaufenden Längsausnehmungen (11, 12) und aus seitlich vorspringenden horizontalen und/oder vertikalen Rastrippen (13, 14) aufweisen, **dadurch gekennzeichnet, dass** zum elektrischen Anschluss der Leuchtdioden (7) auf den Oberseiten der Anschlussgehäuse (1') zur rechten und linken Außenseite hin jeweils eine obere Führungsbohrung (3, 3') mit jeweils einer elektrischen Kontaktierung (8, 8') mit Rastvorrichtung für eines der beiden Anschlussbeine einer der anzuschließenden Leuchtdioden (7) angelegt ist, wobei die beiden Kontaktierungen desselben Anschlussgehäuses (1') einen gemeinsamen elektrischen Spannungsanschluss aufweisen zum Anschluss einer gleich großen positiven oder negativen Spannung zu beiden Außenseiten des Anschlussgehäuses (1'), und dass die elektrischen Kontaktierungen (8, 8') in angrenzenden oberen Führungsbohrungen (3, 3') zweier seitlich unmittelbar benachbarter, durch die Raststruktur (11, 12; 13, 14, 26) verbundener block- oder würfelförmige Anschlussgehäuse (1') mit entgegengesetzter positiver oder negativer Polarität belegbar sind und mit einzelnen Leuchtioden (7) eine elektrische Steckverbindung (8, 8'; 7) bilden, mit welcher in Form einer Steckbrücke in die beiden Kontaktierungen (8, 8') jeweils eines der beiden Beine der Leuchtdiode (7) anschließbar ist,
und dass zur Bildung einer oder mehrerer zu den Längsreihen der Steckmodulplatine senkrechter Platinenreihen aus Steckmodulen (10, 100) auch die weiteren dort angelegten block- oder würfelförmigen Anschlussgehäuse (1') jeweils zur Kontaktierung und Steckverbindung hintereinander liegender Anschlussgehäuse (1') untereinander zur Vorderseite einen Endabschnitt (6, 6') eines überstehenden Kontaktfederstreifens (2, 2') aufweisen,
wobei dieser mit den beiden Kontaktierungen (8, 8') in den oberen Führungsbohrungen (3, 3') an der Oberseite des Anschlussgehäuses (1') durch einen dorthin in diesem geführten, sich in zwei Kontaktabschnitte verzweigenden elektrisch leitenden Abschnitt verbunden ist
und dass die Anschlussgehäuse (1') der Steckmodulplatine (1) ferner eine zur Gehäuserückseite sich öffnende Auslassung (15) aufweisen unter Bildung eines dortigen Rast- und Steckabschnittes (2, 6; 2', 6') in unteren Führungsbohrungen (3a) aus dem dort verlaufenden Abschnitt des Kontaktfederstreifens (2, 2') und dem vorstehenden Abschnitt (6, 6') des Kontaktfederstreifens (2, 2') des in einer senkrechten Reihe anzuschließenden hinteren Anschlussgehäuses,
wobei die elektrisch leitend miteinander verbundenen Kontaktfederstreifen (2, 2') der senkrechten Platinenreihen jeweils einen Leiterstreifen gleicher Polarität bilden.

2. Steckmodulplatine nach Anspruch 1, **dadurch gekennzeichnet,**
**dass** die block- oder würfelförmigen Anschlussgehäuse (1') aus zwei unter Abstufung um 90° durch eine rechtwinkelige Auslassung (15) gegeneinander gerichteten abgestuften Gehäuseansätzen bestehen, wobei ein in der Höhe verjüngter hinterer oberer Gehäuseansatz (17) rechtwinklig gegen einen vorderen tiefer verlaufenden Gehäuseansatz (18) verläuft,
und unter dem oberen Gehäuseansatz (17) die zur Rückseite und zur Unterseite des Anschlussgehäuses (1') sich öffnende Auslassung (15) gegeben ist.

3. Steckmodulplatine nach Anspruch 2, **dadurch gekennzeichnet,**
**dass** im unteren Bereich des vorderen Gehäuseansatzes eine einzige breite, quer durch diesen von der Auslassung (15) zur vorderen Stirnseite des Anschlussgehäuses (1') sich erstreckende breite horizontale untere Führungsbohrung (3a) zur Lagerung des elektrisch leitenden Abschnittes des Kontaktfederstreifens (2, 2') angelegt ist, welcher dort als breiter Kontaktstreifen ausgebildet ist.

4. Steckmodulplatine nach Anspruch 3, **dadurch gekennzeichnet,**
**dass** im hinteren Bereich des oberen Gehäuseansatzes quer oder senkrecht über dessen Höhe sich jeweils eine der im Bereich zur rechten und linken Außenseite erstreckenden oberen Führungsbohrungen (3, 3') zur Anlage der Kontaktierungen (8, 8') angelegt ist.

5. Steckmodulplatine nach Anspruch 2 oder 4, **dadurch gekennzeichnet,**
**dass** durch den vorderen tiefer verlaufenden Gehäuseansatz (18) eine untere Führungsbohrung (3a) zur vorderen Stirnseite verlaufend angelegt ist.

6. Steckmodulplatine nach einem oder mehreren Ansprüchen 1-5, **dadurch gekenzeichnet**,
dass als Kontaktierungen (8, 8') der Diodenbeine in den oberen Führungsbohrungen (3, 3') der zueinander abgewinkelten Gehäuseansätze (17, 18) ein Kontaktfederstreifen (2, 2') mit zwei um 90° nach oben abgebogenen, seitlich rechts und links verlaufenden Kontaktabschnitten angelegt ist, wobei diese nach unten zur vorderen Seite in einen vorderen, unteren breiten gemeinsamen Endabschnitt (6, 6') auslaufen.

7. Steckmodulplatine nach Anspruch 6, **dadurch gekennzeichnet,**
**dass** der breite gemeinsame vordere untere Endabschnitt (6, 6') des Kontaktfederstreifens (2, 2'), welcher aus der breiten unteren Öffnung (4) des Anschlussgehäuses (1, 1') vorragt, als um ca. 360° abgebogener Federabschnitt ausgebildet ist,
und **dass** die Kontaktierung des Kontaktfederstreifens am oberen Ende der Führungsbohrung (3, 3') ebenfalls als um ca. 360° abgebogener Federabschnitt ausgebildet ist.

8. Steckmodulplatine nach einem oder mehreren der Ansprüche 1-7, **dadurch gekennzeichnet,**
**dass** der Kontaktfederstreifen (2, 2') ein um 90° kreissegmentförmig gekrümmtes Bogenstück ist, welches zu seinem oberen Ende hin in zwei Kontaktabschnitte zur Bildung der Kontaktierung (8, 8') eines Beins der Leuchtdioden (7) ausläuft und zum anderen Ende hin in einen einzigen breiteren Endabschnitt (6, 6'), welcher aus der breiten vorderen Öffnung (4) des Anschlussgehäuses (1') mit einer übersteckbaren Kontaktlasche vorsteht.

9. Steckmodulplatine nach einem der Ansprüche 1-8, **dadurch gekennzeichnet,**
**dass** zur Bildung einer gebogenen Oberfläche der Steckmodulplatine (1) aus entsprechend nebeneinander angeordneten und zueinander abgewinkelten senkrechten Reihen von Steckmodulen, welche untereinander in den senkrechten Reihen mit ihren Anschlussgehäusen (1') über Kontaktfederstreifen (2, 2') verbunden sind,
längliche profilierte Verbindungsstangen (19) mit Längsrippen (20) und Längsausnehmungen (21) zwischen den Außenseiten der Steckmodule angelegt sind, die in die seitlich horizontal verlaufenden Längsausnehmungen (11, 12) und in die seitlich horizontal verlaufenden Rastrippen (13, 14) der Anschlussgehäuse (1') passend ausgebildet eingreifen, wobei die Längsrippen (20) gegenüber den Längsausnehmungen (21) im Querschnitt gesehen in einem Winkel entsprechend der gewünschten Krümmung der Oberfläche der Steckmodulplatine zueinander angestellt sind.

10. Steckmodulplatine nach einem oder mehreren der Ansprüche 1 - 9,
**dadurch gekennzeichnet,**
**dass** die einzelnen Verbindungen zwischen den zwei oberen Kontaktierungen (8, 8') in den oberen Führungsbohrungen (3, 3") und dem Kontaktstreifen (2") in der unteren breiten Führungsbohrung (3a) als draht- oder im Querschnitt hülsenförmige Verbindungsteile (22, 23) ausgebildet sind, welche nach Innen mit einem Radius (R1, R2) aufeinander zugebogen sind.

11. Steckmodulplatine nach Anspruch 10,
**dadurch gekennzeichnet,**
**dass** die Abbiegungen der elektrischen Verbindungskontaktteile (22, 23) nach innen aufeinander zu im Bereich der Öffnung der unteren Seite der zwei oberen Führungsbohrungen (3, 3') als Anschlussstellen für aufsteckbare elektronische Bauteile in Form von elektrischen Widerständen und Steckbrücken an der Steckmodulrückseite oder zwei angrenzende Steckmodulrückseiten ausgebildet sind.

12. Steckmodulplatine nach einem oder mehreren der Ansprüche 1 - 11,
**dadurch gekennzeichnet,**
**dass** die Anschlussgehäuse (1') der Steckmodule an deren Rückseite eine konkave horizontale Längsausnehmung (26) als Raststruktur in der Höhe ihrer seitlichen konkaven und konvexen Raststrukturen (11, 13) aufweisen, wobei die gegebenen Längsausnehmungen und konvexen Rastrippen passgenau zueinander ausgebildet und voneinander lösbar sind.

13. Steckmodulplatine nach Anspruch 12,
**dadurch gekennzeichnet,**
**dass** zur seitlichen Verbindung zweier Steckmodule mit zwei gegenüberliegenden horizontalen konkaven Raststrukturen eine gemäß den gegenüberliegenden Ausnehmungen in ihrer Querschnittabmessung zur passgenauen Verbindung ausgeformte Verbindungsstange (29) gegeben ist.

14. Steckmodulplatine nach einem oder mehreren der Ansprüche 1 - 11 sowie nach Anspruch 13.

## Claims

1. A plug-in module circuit board (1) comprising several plug-in modules (10, 100) which can be assembled together having electrical contact-making means with LEDs (7) and/or voltage connection,
where the plug-in modules (10, 100) consist of individual block-shaped or cube-shaped electrical contact means housing (1'), whereas these modules (10, 100) form a plurality of side-by-side electrical contact means housings (1') for the formation of lateral longitudinal rows of plug-in modules for plug-in module circuit boards, which, on at least one of their outer sides, a latching structure (11, 12; 13, 14, 26) of longitudinal recesses (11, 12) extending horizontally and/or perpendicular to each other and horizontal and/or vertical laterally extending grid ribs (13, 14), **characterised in:**
**that** upper guide bores (3, 3') each having electrical contact-making means (8, 8') with a locking device for locking one of the two connecting legs of one of the light emitting diodes (7) to be connected is provided, for electrical connection of the light-emitting diodes on the upper sides of the electrical contact means housing (1') towards the right and left outer sides, wherein the two contact-making means (8, 8') of the same electrical contact means housing (1') have a common electrical voltage connection for connecting an equal positive or negative voltage to both outer sides of the electrical contact means housing (1'),
and **that** to the electrical contact-making means (8, 8') in adjacent upper guide bores (3, 3') of two laterally adjacent block-shaped or cube-shaped electrical contact means housing (1'), connected by the latching structure (11, 12; 13, 14, 26), can be assigned an opposite positive or negative polarity and form an electrical connector (8, 8'; 7) with individual light emitting diodes (7),
with which one of the two legs of the light-emitting diode can respectively be connected in the form of a jumper in the two contact-making means (8, 8'),
and **that** in order to form one or more to the lateral longitudinal rows of the plug-in modular circuit board composed of plug-in modules perpendicular rows out of plug-in modules (10, 100) also these block-shaped or cube-shaped electrical contact means having housings (1') having each to the front side an end section (6, 6') of a protruding contact spring strip (2, 2') for contacting and successive plug-in connection of the electrical contact means housings (1') with each other to the front side. Wherein said contact spring strip is connected to the two contact-making means (8, 8') in the upper guide bores (3, 3') at the top of the electrical contact means housing (1') by an electrically conductive section guided therein and branched into two contact sections
and **that** the electrical contact means housings (1') of the plug-in module board (1) also have an opening (15) which opens towards the rear of the housing by forming a latching and plug-in section (2, 6, 2', 6') in lower guide bores (3a) by the section of the contact spring strip (2, 2') therein and form the protruding section (6, 6') of the contact spring strip (2, 2') of the rear connection housing to be connected in a vertical row, wherein the electrically conductive interconnected contact spring strips (2, 2') of the vertical rows of circuit boards each form a conductor strip of the same polarity.

2. A plug-in module circuit board according to claim 1, that the block-shaped or cube-shaped connection housings (1') consist of two graduated housing extensions which are directed at 90° by gradation through a rectangular clearance (15), wherein a height-tapered rear upper housing extension (17) extends at right angles against a front housing extension (18) running more deeply,
and the clearance opening (15) to the rear side and to the underside of the electrical contact means housing (1') is provided under the upper housing extension (17).

3. A plug-in module circuit board according to claim 2, **characterised in that** a single wide, broad horizontal lower guide bore (3a) for supporting the electrically conductive section of the contact spring strip (2, 2'), formed there as a broad contact strip extends transversely through the latter from the clearance opening (15) to the front end face of the electrical contact means housing (1'), is provided in the lower region of the front housing extension.

4. A plug-in module circuit board according to claim 3, **characterised in that** respectively one of the upper guide bores (3, 3') for applying the contact-making means (8, 8'), extending transversally or perpendicularily over the height thereof, in the region of the right and left outer side, is provided in the rear region of the upper housing extension.

5. A plug-in module circuit board according to claim 2 or 4, **characterised in that** a lower guide bore (3a) for the front end side is designed to extend through the front housing extension (18) running more deeply.

6. A plug-in module circuit board according to one or more of claims 1 to 5, **characterised in that** a contact spring strip (2, 2') is provided with two contact sections bent upwardly at 90°, extending laterally right and left, as contact-making means (8, 8') of the diode legs in the upper guide bores (3, 3') of the housing extensions (17, 18) angled to each other, whereas said contact sections run down to the front side into a front lower wide common end section (6, 6').

7. A plug-in module circuit board according to claim 6, **characterised in that** the wide common front lower end section (6, 6') of the contact spring strip (2, 2'), which protrudes from the wide lower opening (4) of the electrical contact means housing (1, 1'), is formed as a spring section bent by approximately 360°, and that the contacting of the contact spring strip at the upper end of the guide bore (3, 3') is also designed as a spring section bent by approx. 360°.

8. A plug-in module circuit board according to one or more of claims 1 to 7, **characterised in that** the contact spring strip (2, 2') is an 90° arcuate section in the shape of a circular segment, which runs out at its upper end in two contact sections to form the contact-making means (8, 8') of a leg of the light-emitting diodes (7) and at the other end into a single wider end section (6, 6'), which protrudes from the wide front opening (4) of the electrical contact means housing (1') with a pluggable tab.

9. A plug-in module circuit board according to one or more of claims 1 to 8, **characterised in that**, to form a curved upper surface of the plug-in module circuit board (1), vertical rows of plug-in modules arranged correspondingly next to each other and angled towards one another, which are connected to each other in the vertical rows with their electrical contact means housings (1') via contact spring strips (2, 2'),
elongated profiled connecting rods (19) with longitudinal ribs (20) and longitudinal recesses (21) are provided between the outer sides of the plug-in modules, which mesh with an adapted fit into the laterally horizontally extending longitudinal recesses (11, 12) and in the laterally horizontal extending grid ribs (13, 14) of the electrical contact means housing (1'), wherein the longitudinal ribs (20) are arranged with respect to the longitudinal recesses (21) seen in cross-section at an angle corresponding to the desired curvature of the surface of the plug-in module circuit board and with respect to each other.

10. A plug-in module circuit board according to one or more of claims 1 to 9, **characterised in that** the individual connections between the two upper contact-making means (8, 8') in the upper guide bores (3, 3") and the contact strip (2") in the lower wide guide bore (3a) are formed as wire or cross-section sleeve-shaped connecting parts, which are bent inwardly with a radius (R1, R2) towards each other.

11. The plug-in module circuit board according to claim 10, **characterised in that** the bends of the electrical connection contact-making means (22, 23) are provided inwardly towards each other in the region of the opening of the lower side of the two upper guide bores (3, 3') as connection points for pluggable electronic components in the form of electrical resistors and jumpers on the plug-in module rear side or two adjoining plug-in module rear sides.

12. A plug-in module circuit board according to one or more of claims 1 to 11, **characterised in that** the electrical contact means housings (1') of the plug-in modules have at their rear side a concave horizontal longitudinal recess (26) as a latching structure at the level of their lateral concave and convex latching structures (11, 13), wherein the given longitudinal recesses and convex grid ribs are formed to fit each other and are detachable from each other.

13. A plug-in module circuit board according to claim 12, **characterised in that** there is provided a connecting rod (29) shaped according to the opposite recesses (26) in their cross-sectional dimension for accurately fitting connection therewith, for the lateral connection of two plug-in modules with two opposite horizontal concave latching structures (11, 13).

14. A plug-in module circuit board according to one or more of claims 1 - 11 and to claim 13.

## Revendications

1. Platine à modules enfichables, constituée de plusieurs modules enfichables pouvant être assemblés pour former celle-ci, comprenant des connecteurs électriques destinés au montage de diodes électroluminescentes et/ou au branchement d'une tension,
dans laquelle les modules enfichables (10, 100) sont constitués de boîtiers de raccordement (1') individuels en forme de blocs ou de cubes, les modules enfichables (10, 100) se composant, pour former des rangées de platine longitudinales latérales, de plusieurs boîtiers de raccordement (1') qui sont disposés latéralement les uns contre les autres et présentent, sur au moins une de leurs faces extérieures, une structure de verrouillage (11, 12; 13, 14, 26) formée d'évidements longitudinaux (11, 12), s'étendant horizontalement et/ou verticalement les uns par rapport aux autres, et de nervures de verrouillage (13, 14) horizontales et/ou verticales, faisant saillie latéralement, **caractérisée en ce que**
pour le raccordement électrique des diodes électroluminescentes (7), il est prévu sur les faces supérieures des boîtiers de raccordement (1'), vers les côtés externes droit et gauche, respectivement un trou de guidage supérieur (3, 3') doté chacun d'un connecteur électrique (8, 8') avec un dispositif de verrouillage pour l'une des deux pattes de raccordement de l'une des diodes électroluminescentes (7) à brancher, les deux connecteurs d'un même boîtier de raccordement (1') présentant une borne de tension électrique commune, destinée au branchement d'une tension positive ou négative de même valeur, sur les deux côtés externes du boîtier de raccordement (1'), et **en ce que** les connecteurs électriques (8, 8'), dans des trous de guidage supérieurs (3, 3') adjacents de deux boîtiers de raccordement (1') en forme de blocs ou de cubes latéralement directement adjacents et reliés par la structure de verrouillage (11, 12 ; 13, 14, 26), peuvent recevoir une polarité positive ou négative opposée et forment avec des diodes électroluminescentes (7) individuelles une liaison enfichable (8, 8' ; 7) électrique qui, sous la forme d'un pont enfichable, permet de brancher respectivement dans les deux connecteurs (8, 8') l'une des deux pattes de la diode électroluminescente (7), et **en ce que**, pour former une ou plusieurs rangées de platine constituées de modules enfichables (10, 100), perpendiculaires aux rangées longitudinales de la platine à modules enfichables, les autres boîtiers de raccordement (1') en forme de blocs ou de cubes qui y sont installés présentent également, côté face avant, respectivement pour la connexion et la liaison enfichable réciproque de boîtiers de raccordement (1') disposés les uns derrière les autres, une partie d'extrémité (6, 6') d'une bande élastique de contact (2,2') faisant saillie,
sachant que celle-ci est reliée aux deux connecteurs (8, 8') dans les trous de guidage supérieurs (3, 3') sur la face supérieure du boîtier de raccordement (1'), à l'aide d'une portion électriquement conductrice qui est guidée dans le boîtier, jusqu'aux contacts, et se divise en deux portions de contact,
et **en ce que** les boîtiers de raccordement (1') de la platine à modules enfichables (1) présentent en outre un décrochement (15) qui s'ouvre vers l'arrière du boîtier, en y formant une partie de verrouillage et d'enfichage (2, 6 ; 2', 6') dans des trous de guidage inférieurs (3a), à partir de la portion de la bande élastique de contact (2, 2'), qui s'y étend, et de la portion saillante (6, 6') de la bande élastique de contact (2, 2') du boîtier de raccordement arrière, se raccordant dans une rangée verticale,
sachant que les bandes élastiques de contact (2, 2') des rangées de platine verticales, qui sont reliées électriquement entre elles, forment respectivement une bande conductrice de même polarité.

2. Platine à modules enfichables selon la revendication 1, **caractérisée en ce que** les boîtiers de raccordement (1') en forme de blocs ou de cubes se composent de deux portions de boîtier en gradin qui sont décalées l'une par rapport à l'autre en formant un gradin de 90 °, du fait d'un décrochement (15) à angle droit, où une portion de boîtier supérieure (17) arrière, réduite en hauteur, s'étend à angle droit par rapport à une portion de boîtier (18) avant, située plus bas,
et le décrochement (15), qui s'ouvre vers l'arrière et vers le bas du boîtier de raccordement (1'), est prévu sous la portion de boîtier supérieure (17).

3. Platine à modules enfichables selon la revendication 2, **caractérisée en ce que**, dans la partie inférieure de la portion de boîtier avant, il est prévu un trou de guidage inférieur (3a) horizontal large, qui s'étend transversalement dans cette partie, depuis le décrochement (15) jusqu'à la face frontale avant du boîtier de raccordement (1'), et qui est destiné au montage de la portion électriquement conductrice de la bande élastique de contact (2, 2'), laquelle est réalisée à cet endroit sous forme de lame de contact large.

4. Platine à modules enfichables selon la revendication 3, **caractérisée en ce que** dans la partie arrière de la portion de boîtier supérieure, il est prévu, transversalement ou verticalement sur la hauteur de celle-ci, respectivement un des trous de guidage supérieurs (3, 3') qui s'étendent dans la région du côté externe droit et gauche et qui sont destinés au montage des connecteurs (8, 8')

5. Platine à modules enfichables selon la revendication 2 ou 4, **caractérisée en ce qu'**un trou de guidage inférieur (3a) est réalisé à travers la portion de boîtier avant (18), située plus bas, en s'étendant en direction de la face frontale avant.

6. Platine à modules enfichables selon une ou plusieurs des revendications 1 à 5, **caractérisée en ce qu'**il est prévu, en tant que connecteurs (8, 8') des pattes de diode dans les trous de guidage supérieurs (3, 3') des portions de boîtier (17, 18) formant un angle entre elles, une bande élastique de contact (2, 2') comportant deux portions de contact qui s'étendent sur les côtés à droite et à gauche et sont pliées vers le haut à 90 °, lesdites portions se terminant vers le bas, en direction de la face avant, par une large partie d'extrémité (6, 6') inférieure avant commune.

7. Platine à modules enfichables selon la revendication 6, **caractérisée en ce que** la large partie d'extrémité (6, 6') inférieure avant commune de la bande élastique de contact (2, 2'), qui fait saillie à partir de l'ouverture (4) inférieure large du boîtier de raccordement (1, 1'), est réalisée comme partie élastique pliée sous environ 360 °, et **en ce que** le connecteur de la bande élastique de contact, à l'extrémité supérieure du trou de guidage (3, 3'), est également réalisé comme partie élastique pliée sous environ 360 °.

8. Platine à modules enfichables selon une ou plusieurs des revendications 1 à 7, **caractérisée en ce que** la bande élastique de contact (2, 2') est une pièce courbée qui est incurvée sous 90 ° en forme de segment de cercle et se termine, côté extrémité supérieure, par deux portions de contact destinées à former le connecteur (8, 8) pour la patte des diodes électroluminescentes (7), et en direction de son autre extrémité par une partie d'extrémité (6, 6') unique plus large qui fait saillie depuis la large ouverture (4) avant du boîtier de raccordement (1'), avec une patte de contact emboîtable.

9. Platine à modules enfichables selon l'une des revendications 1 à 8, **caractérisée en ce que**, pour former une surface incurvée de la platine à modules enfichables (1), à partir de rangées perpendiculaires de modules enfichables disposées de manière correspondante les unes à côté des autres et formant des angles les unes avec les autres, les modules étant reliés entre eux dans les rangées perpendiculaires avec leurs boîtiers de raccordement (1'), par l'intermédiaire de bandes élastiques de contact (2, 2'), des tiges d'assemblage (19) profilées allongées, dotées de nervures longitudinales (20) et d'évidements longitudinaux (21), sont disposées entre les faces externes des modules enfichables et sont en prise, par des formes adaptées, dans les évidements longitudinaux (11, 12) latéraux horizontaux et dans les nervures de verrouillage (13, 14) latérales horizontales des boîtiers de raccordement (1'), les nervures longitudinales (20) étant inclinées par rapport aux évidements longitudinaux (21), vus en coupe transversale, sous un angle qui correspond à la courbure souhaitée de la surface de la platine à modules enfichables.

10. Platine à modules enfichables selon une ou plusieurs des revendications 1 à 9, **caractérisée en ce que** les différentes liaisons entre les deux connecteurs supérieurs (8, 8') dans les trous de guidage supérieurs (3, 3") et la bande élastique de contact (2"), dans le trou de guidage inférieur (3a) large, sont réalisées en tant qu'éléments de liaison (22, 23) en forme de fils ou, vus en coupe transversale, de manchons qui sont incurvés l'un en direction de l'autre vers l'intérieur, avec un rayon (R1, R2).

11. Platine à modules enfichables selon la revendication 10, **caractérisée en ce que** les parties des éléments de contact de liaison électriques (22, 23) qui sont incurvées vers l'intérieur, l'une en direction de l'autre, dans la région de l'ouverture côté inférieur des deux trous de guidage supérieurs (3, 3'), sont réalisées en tant que bornes de raccordement pour des composants électroniques enfichables se présentant sous la forme de résistances électriques et de ponts enfichables, sur la face arrière du module enfichable ou deux faces arrières adjacentes de modules enfichables.

12. Platine à modules enfichables selon une ou plusieurs des revendications 1 à 11, **caractérisée en ce que** les boîtiers de raccordement (1') des modules enfichables présentent, sur leur face arrière, un évidement longitudinal (26) horizontal concave en tant que structure de verrouillage, à hauteur de leurs structures de verrouillage (11, 13) latérales concaves et convexes, les évidements longitudinaux et les nervures de verrouillage convexes donnés étant réalisés avec des formes ajustées les uns par rapport aux autres et pouvant être séparés les uns des autres.

13. Platine à modules enfichables selon la revendication 12, **caractérisée en ce que** pour l'assemblage latéral de deux modules enfichables avec deux structures de verrouillage horizontales concaves opposées, il est prévu une tige d'assemblage (29) qui est formée, de par sa dimension en coupe transversale, en vue d'un assemblage avec ajustement serré, conformément aux évidements opposés.

14. Platine à modules enfichables selon une ou plusieurs des revendications 1 à 11 ainsi que selon la revendication 13.
